# EUROPEAN PATENT APPLICATION

(11) **EP 4 191 660 A1**
(43) Date of publication of application: **07.06.2023**
(21) Application number: 21850243.3
(22) Date of filing: 21.07.2021
(51) Int. Cl.: H01L 23/12, H01L 23/36, F21V 19/00, F21Y 115/10, H01L 33/62, H05K 1/05

(54) **WIRING BOARD, PACKAGE FOR MOUNTING LIGHT-EMITTING ELEMENT, AND LIGHT-EMITTING DEVICE**

(30) Priority: 29.07.2020 JP 2020128333
(71) Applicant: Kyocera Corporation, Kyoto-shi Kyoto 612-8501 (JP)
(72) Inventor: OKAMOTO, Kazuhiro, Kyoto-shi, Kyoto 612-8501 (JP); YAMAMOTO, Sentarou, Kyoto-shi, Kyoto 612-8501 (JP); MATSUMOTO, Yuhei, Kyoto-shi, Kyoto 612-8501 (JP); OKAWA, Yoshihide, Kyoto-shi, Kyoto 612-8501 (JP)
(74) Representative: Viering, Jentschura & Partner mbB Patent- und Rechtsanwälte
(86) International application number: PCT/JP2021/027374
(87) International publication number: WO 2022/024932

(57) **Abstract**

A wiring board includes a metal substrate, an insulating resin layer positioned on the metal substrate, and an electrical conductor layer positioned on the insulating resin layer. The insulating resin layer includes a first surface facing the metal substrate, a second surface positioned opposite to the first surface, third surfaces positioned between the first surface and the second surface, first ridge portions where the first surface meets the third surfaces, and second ridge portions where the second surface meets the third surfaces. The insulating resin layer includes a first closed pore group closer to the first ridge portions than to the second ridge portions. The first closed pore group includes a plurality of closed pores densely contained.

## Description

### TECHNICAL FIELD

The present disclosure relates to a wiring board, a light emitting element mounting-use package, and a light emitting device.

### BACKGROUND OF INVENTION

In recent years, light emitting diodes (LEDs) and laser diodes (LDs) have been used in headlamps of automobiles. Light source devices using these semiconductor elements are required to have high heat dissipation. In view of this, a metal substrate is used for the light source devices. The metal substrate includes a layered insulating layer made of organic resin, forming a wiring board or a light emitting element mounting-use package (see, for example, Patent Document 1).

### CITATION LIST

### PATENT LITERATURE

Patent Document 1: JP 2013-38452 A

### SUMMARY

A wiring board according to the present disclosure includes a metal substrate, an insulating resin layer positioned on the metal substrate, and an electrical conductor layer positioned on the insulating resin layer. The insulating resin layer includes a first surface facing the metal substrate, a second surface positioned opposite to the first surface, third surfaces positioned between the first surface and the second surface, first ridge portions where the first surface meets the third surfaces, and second ridge portions where the second surface meets the third surfaces. The insulating resin layer includes a first closed pore group closer to the first ridge portions than to the second ridge portions. The first closed pore group includes a plurality of closed pores densely contained.

A wiring board according to the present disclosure includes a metal substrate, an insulating resin layer positioned on the metal substrate, and an electrical conductor layer positioned on the insulating resin layer. The insulating resin layer includes a first surface facing the metal substrate, a second surface positioned opposite to the first surface, a through hole formed from the first surface to the second surface, fourth surfaces positioned between the first surface and the second surface in the through hole, third ridge portions where the first surface meets the fourth surfaces, and fourth ridge portions where the second surface meets the fourth surfaces. The insulating resin layer includes a second closed pore group closer to the third ridge portions than to the fourth ridge portions. The second closed pore group includes a plurality of closed pores densely contained.

A light emitting element mounting-use package according to the present disclosure includes a submount configured to mount a light emitting element and disposed on the wiring board described above.

A light emitting device according to the present disclosure includes a light emitting element provided on the submount of the light emitting element mounting-use package described above.

### BRIEF DESCRIPTION OF THE DRAWINGS

FIG. 1 is an exterior perspective view of a wiring board illustrated as an example of an embodiment.
FIG. 2 is a cross-sectional view taken along line II-II in FIG. 1.
FIG. 3 is a cross-sectional view taken along line III-III in FIG. 1.
FIG. 4 is an enlarged cross-sectional view of a portion P1 in FIG. 2.
FIG. 5 is an exterior perspective view of another aspect of a wiring board.
FIG. 6 is a cross-sectional view taken along line VI-VI in FIG. 5.
FIG. 7 is a cross-sectional view taken along line VII-VII in FIG. 5.
FIG. 8 is an enlarged cross-sectional view of a portion P2 in FIG. 6.
FIG. 9 is a schematic cross-sectional view of a light emitting device illustrated as an example of an embodiment.
FIG. 10A is a cross-sectional view illustrating a laminate body before pressurizing and heating treatment, which is part of a manufacturing process for a wiring board A.
FIG. 10B is a cross-sectional view illustrating the laminate body after the pressurizing and heating treatment, which is part of the manufacturing process for the wiring board A.
FIG. 11A is a cross-sectional view illustrating a laminate body before pressurizing and heating treatment, which is part of a manufacturing process for a wiring board B.
FIG. 11B is a cross-sectional view illustrating the laminate body after the pressurizing and heating, which is part of the manufacturing process for the wiring board B.

### DESCRIPTION OF EMBODIMENTS

The light emitting element mounting-use package disclosed in Patent Document 1 has a structure in which an insulating layer made of organic resin is layered on a metal substrate. Hereinafter, the metal substrate may be referred to as a substrate. The insulating layer made of organic resin may be referred to as an insulating layer. The substrate and the insulating layer are made of different materials. Thus, the substrate is basically less likely to adhere tightly to the insulating layer. For example, when the light emitting element mounting-use package is exposed to a sharp change in temperature, the insulating layer may be peeled from the substrate. This is due to a large difference in coefficient of thermal expansion between the substrate and the insulating layer. The insulating layer is made of organic resin but has high rigidity. The insulating layer made of organic resin has a sharply increased Young's modulus at a surrounding temperature lower than a room temperature (25°C). Due to such factors, the light emitting element mounting-use package having the structure in which the insulating layer made of organic resin is layered on the metal substrate causes the insulating layer to be easily peeled from the substrate.

The present disclosure provides, even in, for example, a structure in which an insulating layer made of organic resin is layered on a metal substrate, a wiring board including the insulating layer less likely to be peeled from the substrate, a light emitting element mounting-use package, and a light emitting device.

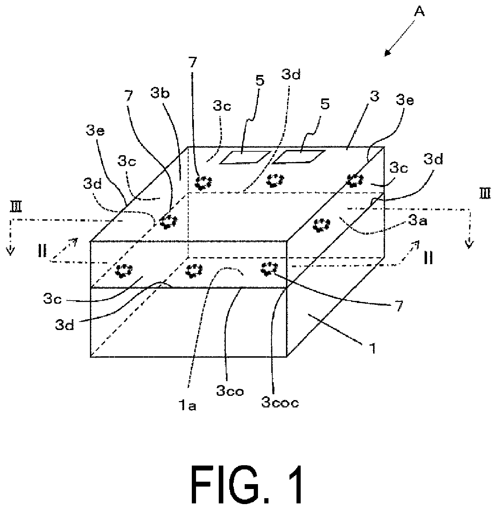

A wiring board, a light emitting element mounting-use package, and a light emitting device of an embodiment will be described in detail below with reference to FIG. 1 to FIG. 9. Note that the present disclosure is not limited to the specific embodiments described below. Also, a disclosed aspect will include various aspects, provided that these aspects fall within the spirit or scope of the general inventive concepts as defined by the appended claims.

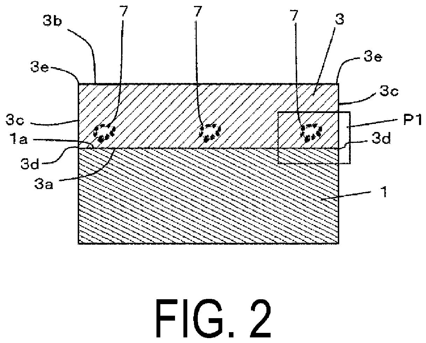

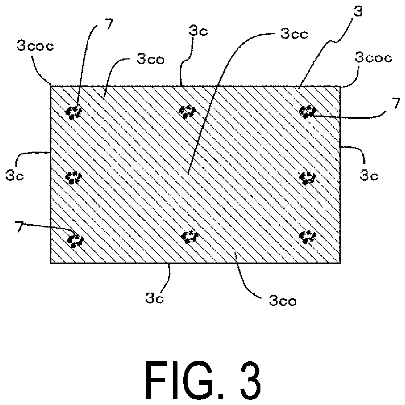

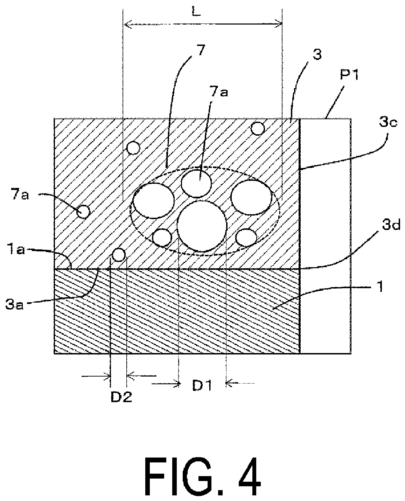

FIG. 1 is an exterior perspective view of a wiring board illustrated as an example of an embodiment. FIG. 2 is a cross-sectional view taken along line II-II in FIG. 1. FIG. 3 is a cross-sectional view taken along line III-III in FIG. 1. FIG. 4 is an enlarged cross-sectional view of a portion P1 in FIG. 2.

A wiring board A illustrated in FIG. 1 includes a metal substrate 1, an insulating resin layer 3, and an electrical conductor layer 5. The insulating resin layer 3 is positioned on the metal substrate 1. The insulating resin layer 3 is layered on the metal substrate 1. The electrical conductor layer 5 is positioned on the insulating resin layer 3 in this case. In FIG. 1, the electrical conductor layer 5 is disposed near an end of a second surface 3b of the insulating resin layer 3, but the position of the electrical conductor layer 5 is not limited to such a position. The electrical conductor layer 5 may be disposed in any location required depending on the pattern design. In FIG. 1, the number of electrical conductor layers 5 is two, but any required number of electrical conductor layers 5 may be disposed.

The insulating resin layer 3 includes a first surface 3a, the second surface 3b, and third surfaces 3c. The first surface 3a is a surface facing the metal substrate 1. The second surface 3b is a surface positioned opposite to the first surface 3a. The third surfaces 3c are surfaces positioned between the first surface 3a and the second surface 3b. The first surface 3a and the second surface 3b are principal surfaces of the insulating resin layer 3. The third surfaces 3c are so-called side surfaces of the insulating resin layer 3. The third surfaces 3c have a direction meeting the first surface 3a or the second surface 3b. In FIG. 1, the third surfaces 3c have a direction perpendicular to the first surface 3a and the second surface 3b but the direction is not limited to the perpendicular direction. The wiring board A illustrated in FIG. 1 includes four third surfaces 3c.

The insulating resin layer 3 includes first ridge portions 3d and second ridge portions 3e. The first ridge portions 3d are at positions where the first surface 3a meets the third surfaces 3c. The second ridge portions 3e are at positions where the second surface 3b meets the third surfaces 3c. The first ridge portions 3d are ridge lines closer to the metal substrate 1 than the second ridge portions 3e is. In FIG. 1, the first ridge portions 3d are disposed surrounding the first surface 3a of the insulating resin layer 3. In FIG. 1, the second ridge portions 3e are disposed surrounding the second surface 3b of the insulating resin layer 3.

The insulating resin layer 3 includes a large number of closed pores 7a. The insulating resin layer 3 includes part where a plurality of closed pores of a large number of the closed pores 7a is densely contained. The part where a plurality of closed pores 7a is densely contained is hereinafter referred to as a closed pore group. The closed pore group in the insulating resin layer 3 of the wiring board A is referred to as a first closed pore group 7. A state with the plurality of closed pores 7a densely contained is referred to as a state where the number of closed pores 7a in a predetermined volume is larger than that in other regions. In this case, the volume may be replaced with a predetermined cross sectional area (unit area) of the insulating resin layer 3. As illustrated in FIG. 4, the unit area is referred to as a circular region that can be drawn by simply connecting contours of the plurality of closed pores 7a positioned at the outermost periphery in the part where the plurality of closed pores is densely contained. In this case, the porosity of the first closed pore group 7 per unit area is preferably not less than 50%. The porosity of the first closed pore group is roughly up to 80%.

The first closed pore group 7 is closer to the first ridge portions 3d than the second ridge portions 3e of the insulating resin layer 3 is. In other words, the first closed pore group 7 is near the first ridge portions 3d in the insulating resin layer 3. More specifically, the first closed pore group 7 is near the outer peripheral edge of the first surface 3a in the insulating resin layer 3.

The region including the first closed pore group 7 has a proportion of resin forming the insulating resin layer 3 lower than other regions in the insulating resin layer 3. Thus, the elastic modulus in the region including the first closed pore group 7 in the insulating resin layer 3 is lower than that in other regions in the insulating resin layer 3. In the wiring board A, part where the elastic modulus is lower than that in other regions is formed near the first ridge portions 3d of the insulating resin layer 3. This can reduce stress produced between the metal substrate 1 and the insulating resin layer 3. As a result, the probability of peeling between the metal substrate 1 and the insulating resin layer 3 can be reduced.

In other words, the likelihood that the insulating resin layer 3 is peeled from the metal substrate 1 can be reduced. When, for example, a coefficient of thermal expansion of the metal substrate 1 differs from that of the insulating resin layer 3, the insulating resin layer 3 is likely to be peeled from peripheral edges 3co. The insulating resin layer 3 is particularly likely to be peeled from its corner portions 3coc. The wiring board A includes the first closed pore group 7 near the first ridge portions 3d in the insulating resin layer 3. Thus, the peeling of the insulating resin layer 3 from its corner portions 3coc or peripheral edges 3co can be reduced. Part including the first closed pore group 7 in the insulating resin layer 3 has a low elastic modulus. The part including the first closed pore group 7 is likely to be deformed. Thus, fixing strength to a surface 1a of the metal substrate 1 improves.

As illustrated in FIG. 2 and FIG. 3, the part including the first closed pore group 7 is a part near the surface 1a of the metal substrate 1 in a thickness direction of the insulating resin layer 3, and is near the peripheral edges 3co of the insulating resin layer 3 in plan view of the insulating resin layer 3. On the other hand, other regions are regions farther from the surface 1a of the metal substrate 1 in the thickness direction of the insulating resin layer 3 than the region including the first closed pore group 7 is and are near a center 3 cc than to the peripheral edges 3co of the insulating resin layer 3 in plan view of the insulating resin layer 3 as illustrated in FIG. 2 and FIG. 3.

As described above, the first closed pore group 7 includes the plurality of closed pores 7a. The closed pores 7a are air holes inside the insulating resin layer 3. The closed pores 7a have a closed space. The closed pores 7a do not face the first surface 3a, the second surface 3b, the side surfaces (third surfaces 3c), or the first ridge portions 3d of the insulating resin layer 3. There is resin between the closed pores 7a and each of the first surface 3a, the second surface 3b, the side surfaces (third surfaces 3c), and the first ridge portions 3d, which are portions forming the insulating resin layer 3.

Thus, the closed pores 7a have no portion open to the first surface 3a, the second surface 3b, the side surfaces (third surfaces 3c), or the first ridge portions 3d of the insulating resin layer 3. In the region other than the part of the first closed pore group 7, a closed pore 7a is independently included in the insulating resin layer 3. The closed pores 7a forming the first closed pore group 7 have a larger average diameter than the closed pores 7a included in the regions other than the part of the first closed pore group 7. An average diameter D1 of the closed pores 7a forming the first closed pore group 7 may be from 1.5 to 5 times as large as an average diameter D2 of the closed pores 7a included in the region other than the part of the first closed pore group 7.

The region including the first closed pore group 7 is identified from a large number of the closed pores 7a included in the insulating resin layer 3 as follows. First, a cross section as illustrated in FIG. 3 is extracted from the wiring board A. Next, the cross section is observed using, for example, an electron microscope to identify the existence of the closed pores 7a from the photograph. Next, a candidate for the first closed pore group 7 as part where the closed pores 7a are densely contained is located, and tentative separation from a region where the closed pores 7a are not densely contained is visually performed.

Next, the diameter of each of the closed pores 7a is obtained through image analysis of the part as the candidate for the first closed pore group 7. The diameter of each of the closed pores 7a is obtained by converting the area of the closed pores 7a obtained through the image analysis into the area of a circle. From a measurement value of the diameter of each of the closed pores 7a obtained, a range including the closed pores 7a having a larger diameter than a threshold is regarded as the range of the first closed pore group 7. In a specific example described below, the threshold of the diameter of the closed pores 7a is 0.05 µm. When a closed pore 7a having a diameter smaller than 0.05 µm is present among the closed pores 7a forming the first closed pore group 7, such a closed pore 7a having a small diameter is also included in the range of the first closed pore group 7. Closed pores 7a having a diameter of not more than 0.01 µm are excluded, and the diameter is not measured. In this manner, the first closed pore group 7 including the plurality of closed pores 7a densely contained is determined.

The metal substrate 1 uses one selected from the group including copper, aluminum, an alloy of copper and aluminum, a clad material with a copper plate and an aluminum plate sticked together, or the like. A thermosetting resin is suitable for the material of the insulating resin layer 3. Epoxy resin is suitably used as the thermosetting resin. The insulating resin layer 3 may include inorganic particles. Copper foil is suitably used as the electrical conductor layer 5.

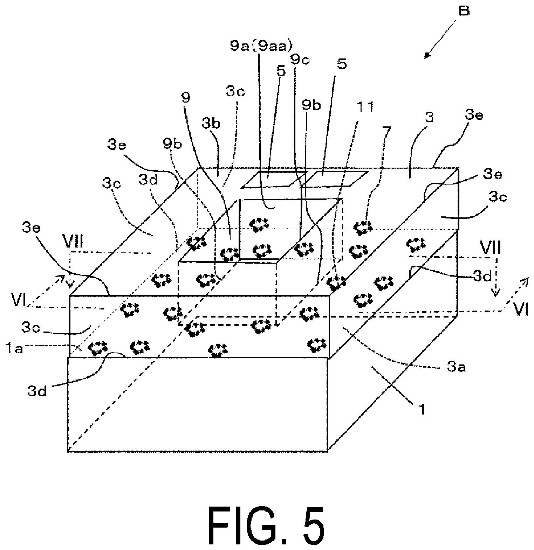

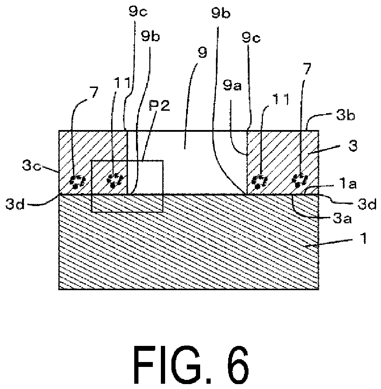

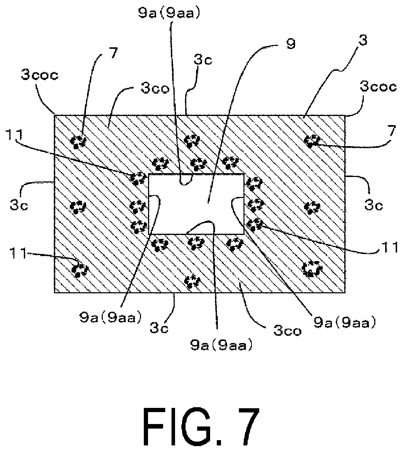

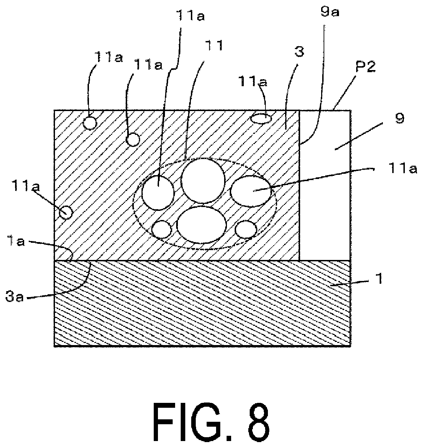

FIG. 5 is an exterior perspective view of another aspect of a wiring board. FIG. 6 is a cross-sectional view taken along line VI-VI in FIG. 5. FIG. 7 is a cross-sectional view taken along line VII-VII in FIG. 5. FIG. 8 is an enlarged cross-sectional view of a portion P2 in FIG. 6.

A wiring board B illustrated in FIG. 5 includes the metal substrate 1, the insulating resin layer 3, and the electrical conductor layer 5. The insulating resin layer 3 is positioned on the metal substrate 1. The electrical conductor layer 5 is positioned on the insulating resin layer 3. In FIG. 5, the electrical conductor layer 5 is disposed near an end of the second surface 3b of the insulating resin layer 3, but the position of the electrical conductor layer 5 is not limited to such a position. The electrical conductor layer 5 is disposed in a location required depending on the pattern design. In FIG. 5, the number of electrical conductor layers 5 is two, but the number of electrical conductor layers 5 required depending on the pattern design may be disposed.

The insulating resin layer 3 includes the first surface 3a and the second surface 3b. The insulating resin layer 3 includes a through hole 9. The wiring board B illustrated in FIG. 5 is different from the wiring board A described above in that the insulating resin layer 3 includes the through hole 9. The through hole 9 is formed penetrating through the insulating resin layer 3 between the first surface 3a and the second surface 3b. The through hole 9 includes inner surfaces 9a. The inner surfaces 9a are positioned between the first surface 3a and the second surface 3b of the insulating resin layer 3. The through hole 9 illustrated in FIG. 5 has a rectangular shape in plan view. The inner surfaces 9a of the through hole 9 include four surfaces. One of the inner surfaces 9a of the through hole 9 is referred to as a fourth surface 9aa. The inner surfaces 9a of the through hole 9 illustrated in FIG. 5 include four fourth surfaces 9aa. The fourth surfaces 9aa all have a direction meeting the first surface 3a.

One fourth surface 9aa of the four fourth surfaces 9aa will be focused on and described. The fourth surface 9aa is positioned between the first surface 3a and the second surface 3b of the insulating resin layer 3. The insulating resin layer 3 includes third ridge portions 9b and fourth ridge portions 9c. As illustrated in FIG. 5 and FIG. 6, the third ridge portions 9b are portions where the first surface 3a and the fourth surface 9aa of the insulating resin layer 3 meet each other. As illustrated in FIG. 5 and FIG. 6, the fourth ridge portions 9c are portions where the second surface 3b and the fourth surface 9aa of the insulating resin layer 3 meet each other.

The insulating resin layer 3 forming the wiring board B also includes a large number of closed pores as in the wiring board A. The insulating resin layer 3 forming the wiring board B also includes a closed pore group having the same configuration as the wiring board A. In the wiring board B, a closed pore group near the through hole 9 formed in the insulating resin layer 3 is referred to as a second closed pore group 11. In the following description, a closed pore forming the second closed pore group 11 is denoted by a reference numeral 11a. The second closed pore group 11 and the closed pores 11a and the first closed pore group 7 and the closed pores 7a are denoted by respective reference numerals for the sake of description. The second closed pore group 11 and the closed pores 11a may have the same size and distribution state as the first closed pore group 7 and the closed pores 7a.

For the wiring board B, the second closed pore group 11 is closer to the third ridge portions 9b than to the fourth ridge portions 9c of the insulating resin layer 3. In other words, the second closed pore group 11 is near the third ridge portions 9b in the insulating resin layer 3. Also in this case, the region including the second closed pore group 11 has a proportion of resin forming the insulating resin layer 3 lower than other regions in the insulating resin layer 3.

Thus, the elastic modulus in the region including the second closed pore group 11 in the insulating resin layer 3 is lower than that in other regions of the insulating resin layer 3. In the wiring board B, part where the elastic modulus is lower than that in other regions is formed near the third ridge portions 9b of the insulating resin layer 3. This can reduce stress produced between the metal substrate 1 and the insulating resin layer 3.

As a result, the probability of peeling between the insulating resin layer 3 on the through hole 9 side and the metal substrate 1 can be reduced. In other words, the likelihood that the through hole 9 side of the insulating resin layer 3 is peeled from the metal substrate 1 can be reduced. When, for example, a coefficient of thermal expansion of the metal substrate 1 differs from that of the insulating resin layer 3, the insulating resin layer 3 is likely to be partially peeled on the inner surface 9a of the through hole 9, which is an end surface the same as the peripheral edges 3co.

The wiring board B includes the second closed pore group 11 near the third ridge portions 9b in the insulating resin layer 3. Thus, the peeling of the insulating resin layer 3 from the inner surface 9a side of the through hole 9 can also be reduced. Part including the second closed pore group 11 in the insulating resin layer 3 has a low elastic modulus. The a part including the second closed pore group 11 is likely to be deformed. Thus, fixing strength to the surface 1a of the metal substrate 1 improves.

As illustrated in FIG. 5 and FIG. 6, the part including the second closed pore group 11 is part near the surface 1a of the metal substrate 1 in the thickness direction of the insulating resin layer 3, and near the inner surface 9a of the through hole 9 in plan view of the insulating resin layer 3. On the other hand, other regions are regions farther from the surface 1a of the metal substrate 1 in the thickness direction of the insulating resin layer 3 than the region including the second closed pore group 11 is, and are near the peripheral edges 3co from the inner surface 9a of the through hole 9 in plan view of the insulating resin layer 3 as illustrated in FIG. 5 and FIG. 6.

As described above, the second closed pore group 11 includes the plurality of closed pores 11a. The closed pores 11a are air holes inside the insulating resin layer 3. The closed pores 11a have a closed space. Thus, the closed pores 11a do not face the first surface 3a, the second surface 3b, the fourth surfaces 9aa, the side surfaces (third surfaces 3c), the first ridge portions 3d, the second ridge portions 3e, or the third ridge portions 9b of the insulating resin layer 3, and resin is provided between the closed pores 11a and the outside of these portions. Thus, the closed pores 11a have no portion open to the first surface 3a, the second surface 3b, the fourth surfaces 9aa, the side surfaces (third surfaces 3c), the first ridge portions 3d, the second ridge portions 3e, or the third ridge portions 9b of the insulating resin layer 3.

Also for the wiring board B, in the region other than the part of the second closed pore group 11, a closed pore 11a is independently included in the insulating resin layer 3. The closed pores 11a forming the second closed pore group 11 have a larger average diameter than the closed pores 11a included in the regions other than the part of the second closed pore group 11. An average diameter D3 of the closed pores 11a forming the second closed pore group 11 may be from 1.5 to 5 times as large as an average diameter D4 of the closed pores 11a included in the region other than the part of the second closed pore group 11.

The wiring board B may include the first closed pore group 7 in the insulating resin layer 3. The wiring board B may include the first closed pore group 7 and the second closed pore group 11 in the insulating resin layer 3. In other words, the insulating resin layer 3 forming the wiring board B may include, near the first ridge portions 3d, the first closed pore group 7 including the plurality of closed pores 7a densely contained. When the wiring board B includes the first closed pore group 7 near the first ridge portions 3d in addition to the second closed pore group 11 near the third ridge portions 9b, the peeling of the insulating resin layer 3 layered on the metal substrate 1 not only from the inner surface 9a side of the through hole 9 but also from the peripheral edges 3co and the corner portions 3coc of the insulating resin layer 3 can be reduced.

For the wiring board A and the wiring board B, the first closed pore group 7 may be positioned throughout the first ridge portions 3d. When the first closed pore group 7 is positioned throughout the first ridge portions 3d, the entirety of the insulating resin layer 3 is less likely to be peeled from the metal substrate 1.

For the wiring board B, the second closed pore group 11 may be positioned throughout the third ridge portions 9b. When the second closed pore group 11 is positioned over the entirety of the third ridge portions 9b, the entirety of the fourth surfaces 9aa of the through hole 9 formed in the insulating resin layer 3 is less likely to be peeled from the metal substrate 1. In this case, being positioned throughout a region means that, as illustrated in FIG. 4, a maximum length L of the first closed pore group 7 is 1 and that the first closed pore group 7 is disposed along the first ridge portions 3d at a pitch of not more than 10 times as long as the maximum length L of the first closed pore group 7. The same applies to the case where the second closed pore group 11 is disposed along the third ridge portions 9b.

As described above, the insulating resin layer 3 may include a plurality of inorganic particles. In such a case, the plurality of inorganic particles preferably has a particle size distribution having two peaks. When the particle size distribution of the inorganic particles included in the insulating resin layer 3 has two peaks, a structure in which the inorganic particles with a small diameter are contained between the inorganic particles with a large diameter included in the insulating resin layer 3 can be formed. Thus, the insulating resin layer 3 having high strength in spite of a low volume ratio of the inorganic particles in the insulating resin layer 3 can be obtained. The insulating resin layer 3 can improve adhesive strength to the metal substrate 1.

The regions of the first closed pore group 7 and the second closed pore group 11 in the insulating resin layer 3 have a high volume ratio of a gap and thus have the low volume ratio of inorganic particles. Thus, the stress relaxation effect due to the presence of the first closed pore group 7 and the second closed pore group 11 in the insulating resin layer 3 can be maintained. In this case, the particle size distribution of the inorganic particles having two peaks means that two peaks can simply be observed when the particle size distribution of the inorganic particles is measured and graphed. For example, the foot extending from a peak of the inorganic particles having a small particle diameter may overlap the foot extending from a peak of the inorganic particles having a large particle diameter.

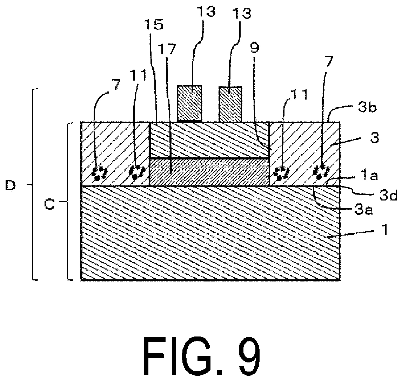

FIG. 9 is a schematic cross-sectional view of a light emitting device D illustrated as an example of the embodiment. The light emitting device D illustrated in FIG. 9 includes a light emitting element mounting-use package C and a light emitting element 13. Examples of the light emitting element 13 include laser diodes (LD) in addition to LED elements.

The light emitting element mounting-use package C illustrated in FIG. 9 is based on the wiring board B illustrated in FIG. 6. The light emitting element mounting-use package C includes the wiring board B, a submount substrate 15, and a bonding material 17. The submount substrate 15 is fit into the through hole 9 formed in the insulating resin layer 3 forming the wiring board B. The submount substrate 15 is disposed on the metal substrate 1 forming the wiring board B. The bonding material 17 is disposed on the metal substrate 1 and in the through hole 9 formed in the insulating resin layer 3 forming the wiring board B. The bonding material 17 bonds the metal substrate 1 to the submount substrate 15.

To mount the light emitting element 13 that is likely to generate heat when actuated, the submount substrate 15 preferably has properties including high thermal conductivity, high strength, high toughness, and low thermal expansion. For the sake of such properties, a ceramic is preferably used for the submount substrate 15. For example, a ceramic including silicon nitride as a main component is preferably used. Solder, Au-Sn, and the like are preferably used for the bonding material 17. The submount substrate 15, the metal substrate 1, and the insulating resin layer 3 may have a different coefficient of thermal expansion.

When the light emitting element 13 mounted on the light emitting element mounting-use package C operates continuously or discontinuously, the light emitting element mounting-use package C generates heat due to the operation of the light emitting elements 13. The metal substrate 1 and the insulating resin layer 3 bonded to each other have a different coefficient of thermal expansion and Young's modulus, thus producing thermal stress therebetween. For the light emitting device D, the insulating resin layer 3 of the wiring board B forming the light emitting element mounting-use package C includes the second closed pore group 11 as described above. Thus, the insulating resin layer 3 is less likely to be peeled from the metal substrate 1 even when the thermal stress is produced between the metal substrate 1 and the insulating resin layer 3. Thus, the light emitting device D or the light emitting element mounting-use package C having high reliability can be obtained.

The light emitting device D having high reliability can be similarly obtained when the wiring board A is used for the light emitting element mounting-use package C. When the wiring board A is used, the submount substrate 15 is disposed on the second surface 3b of the insulating resin layer 3 of the wiring board A. In this case, the submount substrate 15 is disposed on the second surface 3b of the insulating resin layer 3 with the bonding material 17 in between.

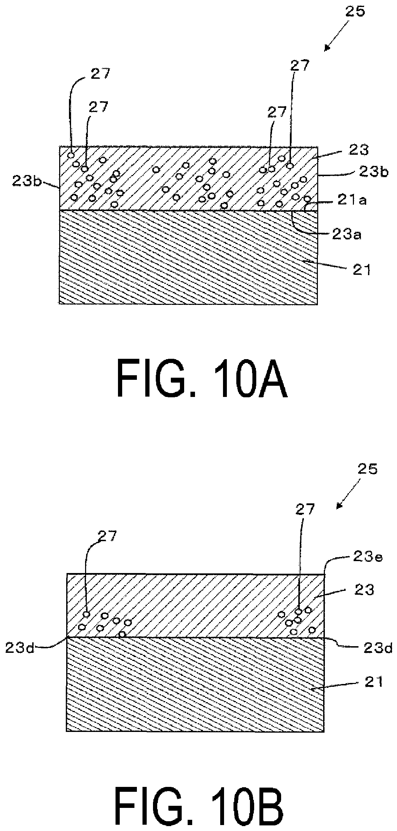

Next, a method of manufacturing the wiring board A and the wiring board B will be described. FIG. 10A and FIG. 10B illustrate part of a manufacturing process of the wiring board A. FIG. 10A is a cross-sectional view illustrating a laminate body before pressurizing and heating treatment. FIG. 10B is a cross-sectional view illustrating the laminate body after pressurizing and heating treatment.

First, a metal plate 21 and an organic resin sheet 23 are prepared. The metal plate 21 is a material for obtaining the metal substrate 1. The organic resin sheet 23 is a material for obtaining the insulating resin layer 3. The metal plate 21 and the organic resin sheet 23 are each machined into a predetermined shape. It is preferable to use a mechanical cutting machine such as one that performs dicing in order to machine the metal plate. Thermosetting resin is preferably used for a material of the organic resin sheet 23. Epoxy resin is preferably used as a material of the thermosetting resin. A hardener may be added to the thermosetting resin. The organic resin sheet 23 may include inorganic particles. Silica, alumina, and the like are preferably used as the inorganic particles. In this case, the inorganic particles preferably have two peaks in the particle size distribution measured.

Next, a laminate body 25 is produced by bonding the organic resin sheet 23 on a surface 21a of the metal plate 21. The metal plate 21 and the organic resin sheet 23 are bonded by a laminating machine that can apply pressure in a heated state. In the present disclosure, the thermosetting resin is cured at a temperature higher than the temperature at which the thermosetting resin used is curable as a curing condition of the thermosetting resin. When, for example, epoxy resin is used as the thermosetting resin, the epoxy resin is cured at approximately 200°C. In the present disclosure, the curing temperature is set to a temperature higher than this temperature by 10°C or higher and 60°C or lower. Setting the curing temperature to higher than the curable condition causes the surface of the insulating resin layer 3 to be likely flat due to the resin component partially dissolving during the pressurizing and heating. This curing process is maintained at the maximum temperature for a predetermined period of time. When the laminate body 25 is produced under such a condition, bubbles 27 contained inside the organic resin sheet 23 are released from the organic resin sheet 23.

The bubbles 27 are likely to be released from a surface of the organic resin sheet 23 not in contact with the metal plate 21 but are less likely to be released from a surface 23a facing the metal plate 21. This is because the bubbles 27 that are supposed to be released from the organic resin sheet 23 are blocked by the metal plate 21 due to the surface 23a of the organic resin sheet 23 in contact with the metal plate 21. Thus, the bubbles 27 are likely to accumulate near the surface 23a of the organic resin sheet 23 facing the metal plate 21.

In other words, the bubbles 27 dispersed in the organic resin sheet 23 will concentrate near the surface 23a facing the metal plate 21. Thus, the ratio of the open pores on the surface of the insulating resin layer 3 can be reduced. To facilitate the release of the bubbles, a film sheet with open pores is layered on the surface of the organic resin sheet 23 opposite to the metal plate 21.

As illustrated in FIG. 10B, the bubbles 27 originally included in the organic resin sheet 23 move toward, during a first stage of the pressurizing and heating treatment, part of the organic resin sheet 23 that is not in contact with the metal plate 21 and is open. The part of the organic resin sheet 23 that is open is, for example, a side surface 23b of the organic resin sheet 23. Thus, the first closed pore group 7 including the plurality of closed pores densely contained is formed in the insulating resin layer 3 formed by curing the organic resin sheet 23. The first closed pore group 7 is formed in a region near the side surfaces (third surfaces 3c) of the insulating resin layer 3 and near the metal plate 21.

For the wiring board A, the organic resin sheet 23 has a simple plate shape, and thus the bubbles 27 included in the organic resin sheet 23 concentrate in a region near the side surface 23b of the organic resin sheet 23. Thus, the wiring board A can be obtained. The wiring board A includes the first closed pore group 7 that is closer to the first ridge portions 3d than to the second ridge portions 3e of the insulating resin layer 3 and includes the plurality of closed pores 7a densely contained.

When the holding time is short, the dissolution of part of the resin component does not proceed, and thus the surface is less likely to be flat. When the curing temperature is set to around the normal temperature (200°C for example) described above, the insulating resin layer 3 is likely to have an uneven surface, and open pores are likely to be formed. This is because the resin component is less likely to dissolve during the pressurizing and heating.

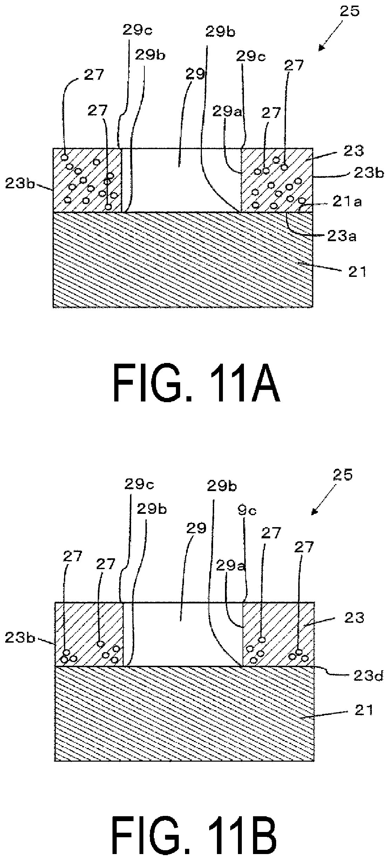

FIG. 11A and FIG. 11B illustrate part of a manufacturing process of the wiring board B. FIG. 11A is a cross-sectional view illustrating a laminate body before pressurizing and heating treatment. FIG. 11B is a cross-sectional view illustrating the laminate body after pressurizing and heating treatment. In manufacturing the wiring board B, the organic resin sheet 23 forms a hole 29, which will be the through hole 9 of the insulating resin layer 3. The hole 29 is formed using a laser beam machine in addition to a mold. In the wiring board B, the hole 29 is formed in the organic resin sheet 23, and thus the bubbles 27 also concentrate in a region near an inner surface 29a of the hole 29. As illustrated in FIG. 11B, in the wiring board B, the bubbles 27 concentrate both in the region near the side surface 23b of the organic resin sheet 23 and in the region near the inner surface 29a of the hole 29. Thus, the wiring board B can be obtained. The wiring board B includes the second closed pore group 11 that is closer to the third ridge portions 9b than to the fourth ridge portions 9c of the through hole 9 formed in the insulating resin layer 3 and includes the plurality of closed pores densely contained. The third ridge portions 9b are positioned away from the metal substrate 1, and the fourth ridge portions 9c are positioned near the metal substrate 1. In the wiring board B, the bubbles 27 concentrate at the position as in the wiring board A at this time, also forming the first closed pore group 7. Also in manufacturing the wiring board B, to facilitate the release of the bubbles, a film sheet with open pores is layered on the surface of the organic resin sheet 23 opposite to the metal plate 21.

In manufacturing the wiring board A and the wiring board B, using the inorganic particles whose particle size distribution has two peaks in measuring the particle size distribution for the organic resin sheet 23 improves mechanical strength of the insulating resin layer 3 formed by the organic resin sheet 23, allowing the adhesive strength of the insulating resin layer 3 to the metal substrate 1 to be improved.

Next, a method of manufacturing a light emitting device will be described. Here, an example where the wiring board B is applied to the light emitting element mounting-use package is described.

First, the bonding material 17 is disposed in the through hole 9 of the wiring board B produced. Next, the submount substrate 15 is disposed on the upper surface of the bonding material 17, and a heating treatment is performed. Next, the light emitting element 13 is mounted on the surface of the submount substrate 15. The light emitting element 13 is electrically connected by a bonding wire to the electrical conductor layer 5 provided on the second surface 3b of the insulating resin layer 3 forming the wiring board B. Thus, the light emitting device D can be obtained.

### EXAMPLE

The wiring board was produced and reliability was evaluated. The wiring board B was produced as the wiring board. Aluminum was used for the metal substrate. The organic resin sheet to be the insulating resin layer was produced by mixing epoxy resin and silica particles. The content of the silica particles was 30% by volume. For the silica particles, two types of raw materials were used, one with two peaks in the particle size distribution and one with one peak in the particle size distribution. In addition, 1 part by mass of a curing agent (dicyandiamide) was added to 100 parts by mass of the epoxy resin. The through hole of the insulating resin layer was formed using a mold. The electrical conductor layer was formed by an electrolytic plating method using a plating solution of nickel containing zinc.

Table 1 lists conditions for pressurizing and heating in producing the laminate body. A film sheet with open pores was layered on a surface of the insulating resin layer opposite to the metal substrate. The size of the wiring board produced is as follows. The area of the flat surface of the metal substrate and the insulating resin layer is 40 mm × 40 mm. The area of the through hole provided in the insulating resin layer is 20 mm × 20 mm. The thickness of the metal substrate is 2 mm. The thickness of the insulating resin layer is 0.2 mm.

The following evaluations were performed on the produced sample. The evaluation items are: presence or absence of the first closed pore group and the second closed pore group formed in the insulating resin layer; presence or absence of peeling of the insulating resin layer from the metal substrate; presence or absence of a crack produced in the insulating resin layer; and the adhesive strength of the insulating resin layer to the metal substrate.

Presence or absence of the first closed pore group and the second closed pore group formed in the insulating resin layer was confirmed as follows. First, a cross section as illustrated in FIG. 3 was obtained from the wiring board produced. Next, for example, the cross section was observed using a scanning electron microscope, to check where closed pores were in the photograph. Next, a candidate for the first closed pore group and the second closed pore group as part where the closed pores were densely contained was located, and tentative separation from a region where the closed pores were not densely contained was visually performed. Next, the diameter of each of the closed pores was obtained through image analysis of the part as the candidate for the first closed pore group and the second closed pore group. The diameter of each of the closed pores was obtained by converting the area of the closed pores obtained through the image analysis into the area of a circle. From a measurement value of the diameter of each of the closed pores obtained, a range including the closed pores having a larger diameter than a threshold was regarded as the ranges of the first closed pore group and the second closed pore group. A threshold of the diameter of the closed pores was 0.05 µm. When a closed pore having a diameter smaller than 0.05 µm is present among the closed pores forming the first closed pore group and the second closed pore group, such a closed pore having a small diameter was also included in the region of the first closed pore group and the second closed pore group. The closed pores with a diameter that was not more than 0.01 µm were not subjected to the measurement, that is, excluded from the measurement target. It was confirmed that the second closed pore group was formed closer to the third ridge portions than to the fourth ridge portions in the insulating resin layer in the wiring board produced. It was also confirmed that the second closed pore group was formed over the entire circumference of the inner walls (inner surfaces) formed by the four surfaces (fourth surfaces) forming the through hole. The porosity of each of the first closed pore group and the second closed pore group was not less than 50%. In this case, the maximum porosity of the first closed pore group and the second closed pore group was 70%.

Presence or absence of peeling of the insulating resin layer from the metal substrate was evaluated using a method of immersion in a soldering pot set to 300°C for 30 seconds.

Presence or absence of a crack produced in the insulating resin layer was confirmed using a method of checking after a temperature cycle test. The conditions for the temperature cycle test were that the minimum temperature was -55°C, the maximum temperature was 150°C, and the holding time at the minimum temperature, the holding time at the maximum temperature, and the time for changing the temperature from the minimum temperature to the maximum temperature or vice versa were each 15 minutes. The number of temperature cycles was set to 3000.

A state in which the insulating resin layer was peeled or cracked was confirmed by a method of immersion in a red check liquid. Samples in which ingress of the red check liquid into the insulating resin layer was observed were determined to be defective. At the same time, the ingress of the red check liquid into between the metal substrate and the insulating resin layer was also evaluated.

The adhesive strength of the insulating resin layer to the metal substrate was measured using a tensile tester (autograph). The evaluations were each performed with the number of samples being 10. In this case, when peeling or a crack was found in at least one of the evaluated samples (10 samples), the sample was evaluated as "Present". An average value was determined for the adhesive strength.

**[Table 1]**

| Sample No. | Particle size distribution of inorganic particles (number of peaks) | Particle diameter at peak position | Forming condition of laminate body | | Presence or absence of first closed pore group | Presence or absence of second closed pore group | Presence or absence of open pores | Evaluation | | |
|---|---|---|---|---|---|---|---|---|---|---|
| | | | Maximum temperature | Holding time | | | | Presence or absence of peeling of insulating resin layer from metal substrate | Presence or absence of crack in insulating resin layer | Adhesive strength of insulating resin layer to metal substrate |
| | Number | µm | °C | h | Present or absent | Present or absent | Present or absent | Present or absent | Present or absent | MPa |
| 1 | 2 | 0.5 or 2.5 | 250 | 4 | Present | Present | Absent | Absent | Absent | 3.0 |
| 2 | 1 | 2.5 | 250 | 4 | Present | Present | Absent | Absent | Present | 1.1 |
| 3 | 2 | 0.5 or 2.5 | 250 | 1 | Present | Present | Present | Absent | Present | 1.5 |
| 4 | 2 | 0.5 or 2.5 | 200 | 4 | Absent | Absent | Present | Present | Present | 1.4 |

As is clear from the results in Table 1, in the sample (sample No. 4) with the first closed pore group and the second closed pore group not formed in the insulating resin layer, peeling of the insulating resin layer from the metal substrate was found. The insulating resin layer was partially peeled from its corner portions. The peeled portion was also found in the inner surface of the through hole.

On the other hand, in the samples (sample Nos. 1, 2, and 3) with the first closed pore group and the second closed pore group formed in the insulating resin layer, no peeling of the insulating resin layer from the metal substrate was found. Of these samples, in the sample (sample No. 1) using, for the insulating resin layer, the inorganic particles whose particle size distribution has two peaks and having the maximum temperature of 250°C and the holding time of four hours as forming conditions of the laminate body, no crack was found in the insulating resin layer. The adhesive strength of the insulating resin layer to the metal substrate was 3 MPa. In the sample (sample No. 2) having the maximum temperature of 250°C and the holding time of four hours as forming conditions of the laminate body and using the inorganic particles whose particle size distribution has only one peak, the adhesive strength of the insulating resin layer to the metal substrate was 1.1 MPa lower than in the sample No. 1, and a crack was found in the insulating resin layer. In the sample (sample No. 3) using the inorganic particles whose particle size distribution has two peaks and having the maximum temperature of 250°C and the holding time of one hour as forming conditions of the laminate body, the adhesive strength of the insulating resin layer to the metal substrate was 1.5 MPa lower than in the sample No. 1, and a crack was found in the insulating resin layer. Note that the cracks found in samples Nos. 2 and 3 had a size small enough not to compromise the performance of the wiring board.

### REFERENCE SIGNS

A, B Wiring board
C Light emitting element mounting-use package
D Light emitting device
1 Metal substrate
3 Insulating resin layer
3a First surface
3b Second surface
3c Third surface
3d First ridge portion
3e Second ridge portion
5 Electrical conductor layer
7 First closed pore group
7a, 11a Closed pore
9 Through hole
9a Inner surface
9aa Fourth surface
9b Third ridge portion
9c Fourth ridge portion
11 Second closed pore group
13 Light emitting element
15 Submount substrate
17 Bonding material

## Claims

1. A wiring board, comprising:
a metal substrate;
an insulating resin layer positioned on the metal substrate; and
an electrical conductor layer positioned on the insulating resin layer, wherein
the insulating resin layer comprises:
a first surface facing the metal substrate;
a second surface positioned opposite to the first surface;
third surfaces positioned between the first surface and the second surface;
first ridge portions where the first surface meets the third surfaces; and
second ridge portions where the second surface meets the third surfaces, and
the insulating resin layer comprises a first closed pore group closer to the first ridge portions than to the second ridge portions, and the first closed pore group comprises a plurality of closed pores densely contained.

2. A wiring board, comprising:
a metal substrate;
an insulating resin layer positioned on the metal substrate; and
an electrical conductor layer positioned on the insulating resin layer, wherein
the insulating resin layer comprises:
a first surface facing the metal substrate;
a second surface positioned opposite to the first surface;
a through hole formed from the first surface to the second surface;
fourth surfaces positioned between the first surface and the second surface in the through hole;
third ridge portions where the first surface meets the fourth surfaces; and
fourth ridge portions where the second surface meets the fourth surfaces, and
the insulating resin layer comprises a second closed pore group closer to the third ridge portions than to the fourth ridge portions, and the second closed pore group comprises a plurality of closed pores densely contained.

3. The wiring board according to claim 2, wherein
the insulating resin layer comprises:
third surfaces positioned between the first surface and the second surface;
first ridge portions where the first surface meets the third surfaces; and
second ridge portions where the second surface meets the third surfaces, and
the insulating resin layer comprises a first closed pore group closer to the first ridge portions than to the second ridge portions, and the first closed pore group comprises a plurality of closed pores densely contained.

4. The wiring board according to claim 1 or 3, wherein the first closed pore group is disposed throughout the first ridge portions.

5. The wiring board according to claim 2 or 3, wherein the second closed pore group is disposed throughout the third ridge portions.

6. The wiring board according to any one of claims 1 to 5, wherein
the insulating resin layer comprises a plurality of inorganic particles, and
the plurality of inorganic particles has a particle size distribution having two peaks.

7. A light emitting element mounting-use package, comprising
a submount substrate configured to mount a light emitting element and disposed on the wiring board according to any one of claims 1 to 6.

8. A light emitting device, comprising
a light emitting element provided on the submount substrate of the light emitting element mounting-use package according to claim 7.
